Europäisches Patentamt

European Patent Office

Office européen des brevets

(19)

(11) Veröffentlichungsnummer: **0 243 528 B1**

(12)

# EUROPÄISCHE PATENTSCHRIFT

(45) Veröffentlichungstag der Patentschrift: **18.12.91**

(51) Int. Cl.5: **G11C 19/00**, G11C 19/18

(21) Anmeldenummer: **86106049.9**

(22) Anmeldetag: **02.05.86**

(54) **Serieller FIFO-Speicher.**

(43) Veröffentlichungstag der Anmeldung:
**04.11.87 Patentblatt 87/45**

(45) Bekanntmachung des Hinweises auf die
Patenterteilung:
**18.12.91 Patentblatt 91/51**

(84) Benannte Vertragsstaaten:
**DE FR NL**

(56) Entgegenhaltungen:
**FR-A- 2 212 703**
**FR-A- 2 236 249**
**US-A- 3 708 690**

(73) Patentinhaber: **Deutsche ITT Industries GmbH
Hans-Bunte-Strasse 19 Postfach 840
W-7800 Freiburg i.Br.(DE)**

(72) Erfinder: **Giebel, Burkhard, Dipl.-Ing.
Berliner Strasse 25/2
W-7809 Denzlingen(DE)**
Erfinder: **Theus, Ulrich, Dr.-Ing.
Schönbergstr. 5b
W-7803 Gundelfingen(DE)**

## Beschreibung

Die Erfindung betrifft einen seriellen FIFO-Speicher mit Isolierschicht-Feldeffekttransistoren desselben Leitungs- und Steuerungstyps, also beispielsweise mit N-Kanal-Enhancement-Transistoren, und mit n signalflußmäßig parallelen Signalzweigen, deren Eingänge mit dem Signaleingang des Speichers und deren Ausgänge mit dessen Signalausgang gekoppelt sind, wobei jeder Signalzweig m Transfertransistoren enthält, deren Source-Drain-Strecken signalflußmäßig in Reihe liegen und die Gates der Transfertransistoren jedes Signalzweigs mit Taktsignalen gespeist sind, deren wirksame Impulse in Richtung vom m-ten zum ersten Transfertransistor so zeitlich aufeinanderfolgen, daß sie nacheinander leitend gesteuert werden, vgl. den Oberbegriff des Anspruchs 1. ("FIFO" ist die Abkürzung von Englisch "First-In First-Out".)

Eine derartige Anordnung von Transfertransistoren ist in der Offenlegungsschrift DE-A 24 30 349 als Teil eines nach dem Ladungsverschiebeprinzip, insb. nach dem Eimerkettenschaltungsprinzip, aufgebauten Speichers beschrieben, und zwar sind die Signalzweige dort als Querketten bezeichnet. Die Eingänge der Signalzweige und deren Ausgänge liegen jeweils an Abgriffen zweier weiterer Reihenschaltungen von Transfertransistoren, die in der genannten Offenlegungsschrift als Längsketten bezeichnet sind. Diese sind jeweils für sich von eigenen Taktsignalen betrieben, wie dies für Anordnungen nach dem Ladeverschiebungsprinzip charakteristisch ist.

Die vorbeschriebene Anordnung eignet sich insbesondere zur Speicherung und damit auch Verzögerung von Analogsignalen, zu denen als Grenzfall reine Digitalsignale gerechnet werden können.

Sollen lediglich Digitalsignale im Sinne des First-In-First-Out-Prinzips (FIFO) gespeichert und damit verzögert werden, so ist die vorbeschriebene Anordnung vom Bedarf an Kristallfläche der zur Realisierung vorgesehenen integrierten Schaltung her gesehen zu aufwendig, zumal jedem Transfertransistor bei der vorbeschriebenen Anordnung ein Kondensator zugeordnet sein muß, der ebenfalls Fläche beansprucht.

Aus US-A 3,708,609 ist ein quadratisch angeordnetes Vielfachphasen-Schieberegister für Datensignale bekannt, das eine Anzahl m (dort mit n bezeichnet) von parallelen Signalzweigen mit jeweils m einzelnen Zellen aufweist, wobei m in der Regel größer als 3 ist. Die Datensignale werden so durch die einzelnen Signalzweige geschoben, daß der Inhalt der letzten Zelle zuerst der Ausgangsklemme zugeführt wird und danach der Inhalt der vorletzten Zelle in die jetzt freigewordene letzte Zelle. Dieser Schiebevorgang setzt sich solange in Richtung des Eingangs fort, bis der gesamte Inhalt dieses Signalzweiges jeweils um eine Zelle weitergeschoben worden ist. Danach wird die leere erste Zelle mit einem neuen Datensignal, also einem neuen Bit, gespeist.

Der Schiebetakt der parallel liegenden Signalzweige ist mit dem Datentakt des zugeführten Datensignals synchronisiert. Der zyklisch ablaufenden Schiebefolge innerhalb eines Signalzweiges entspricht die zyklisch gesteuerte Schiebefolge der parallel liegenden Signalzweige. Diese beiden zyklisch ablaufenden Schiebefolgen werden ständig wiederholt, so daß aufeinanderfolgende Bits der zugeführten Datensignale in aufeinanderfolgenden Signalzweigen abgespeichert sind, deren Reihenfolge sich ebenfalls zyklisch wiederholt. Am Ausgang des Schieberegisters werden die einzelnen Signalzweige in der gleichen zyklischen Reihenfolge wieder angesteuert, so daß die Bitfolge des Ausgangssignals gegenüber dem Eingangssignal nicht vertauscht wird.

Nach einem ersten Ausführungsbeispiel in US-A 3,708,690 ist die Folge der Taktsignale in aufeinanderfolgenden Signalzweigen jeweils um ein Taktsignal verzögert - dadurch wird gleichzeitig die Aufteilung der einzelnen Bits auf die verschiedenen Signalzweige bewirkt. Nach einem anderen Ausführungsbeispiel werden die in der Reihenfolge zahlengleichen Zellen aller Signalzweige mit dem gleichen Taktsignal gespeist. Die Aufteilung der einzelnen Bits auf die einzelnen Signalzweige und ihre Zusammenführung am Ende erfolgt durch zusätzliche Zellen am Anfang und Ende, die mit zeitlich getrennten Taktsignalen angesteuert sind. Für die zeitliche Trennung dieser Taktsignale wird die zyklische Taktsignalfolge verwendet.

Die Periodendauer des an einer Zelle liegenden Taktsignales, also des jeweiligen Schiebetaktes, gegenüber dem eingangsseitigen Datentakt ist um dem Faktor m ( = Anzahl der parallelen Signalzweige) vergrößert. Die Speicherzeit des Schieberegisters ergibt sich damit aus dem eingangsseitigen Datentakt und der der jeweiligen Zahl m.

Der in den Ansprüchen gekennzeichneten Erfindung liegt die Aufgabe zugrunde, ausgehend von dem vorbeschrieben Vielfachphasen-Schieberegister eine Anordnung zur Signalverzögerung anzugeben, in der die Speicherzeit um eine in einem Variationsbereich liegende Anzahl von Datentaktperioden verkürzt werden kann, wobei die jeweilige wirksame Verzögerungszeit während des Betriebes einstellbar sein soll.

An sich lassen sich FIFO-Speicher mittels der bekannten dynamischen Random Access Memories (DRAMs) realisieren. Allerdings ist dabei eine geeignete Adressierung erforderlich. Ferner ist bis zu einer Speichergröße von etwa 5 kBit der Kristallflächenaufwand wegen des beträchtlichen Anteils des sogenannten Overhead derart erheblich,
daß nach geeigneten Ausweichmöglichkeiten zu suchen ist. Zum Overhead zählen alle diejenigen Teilschaltungen, die zusätzlich zu den eigentlichen Speicherzellen erforderlich sind und zu deren sicheren Betrieb benötigt werden, nämlich z.B. die sogenannten Dummy-Zellen, die Adressier-und Precharge-Stufen für die Bit- und Wortleitungen, die Schreib- und Leseverstärker, die Eingangs- und Ausgangs-Pufferschaltungen etc..

Man hat auch schon Schieberegister für FIFO-Speicher benutzt, da diese den erwähnten Nachteil des Overhead praktisch nicht aufweisen. Allerdings muß das Taktsignal des Schieberegisters eine Frequenz haben,
die gleich der Datenrate der Eingangssignale ist. Dies führt insbesondere bei hohen Taktfrequenzen zu nicht unerheblichen Verlustleistungen des Schieberegisters.

Demgegenüber reduziert sich bei der Anordnung nach US-A-3 708 605 die auftretende Verlustleistung wegen der um den Faktor n reduzierten Taktfrequenz in den parallelen Signalzweigen etwa auf den n-ten Teil der bei einem üblichen Schieberegister auftretenden Verlustleistung, wobei mit n die Anzahl der parallelen Signalzweige und gleichzeitig die Anzahl der für die Gesamtanordnung erforderlichen Taktsignale ist. Außerdem entspricht einer üblichen Schieberegisterzelle, die selbst bei dynamischen MOS-Schaltungen aus mindestens sechs Transistoren besteht, bei dieser Anordnung nur ein Transfertransistor mit zugehörigem Pegelregenerierer, was z.B. lediglich drei Transistoren erfordert.

Die Erfindung wird nun anhand der Figuren der Zeichnung näher erläutert.

Fig. 1   zeigt in stark schematischer Darstellung das Schaltbild eines Ausführungsbeispiels der Anordnung,

Fig. 2   zeigt wiederum stark schematisiert eine Abwandlung der Anordnung, und

Fig. 3   zeigt eine Anordnung nach Fig. 1 mit verkürzter Speicherzeit gemäß der Erfindung.

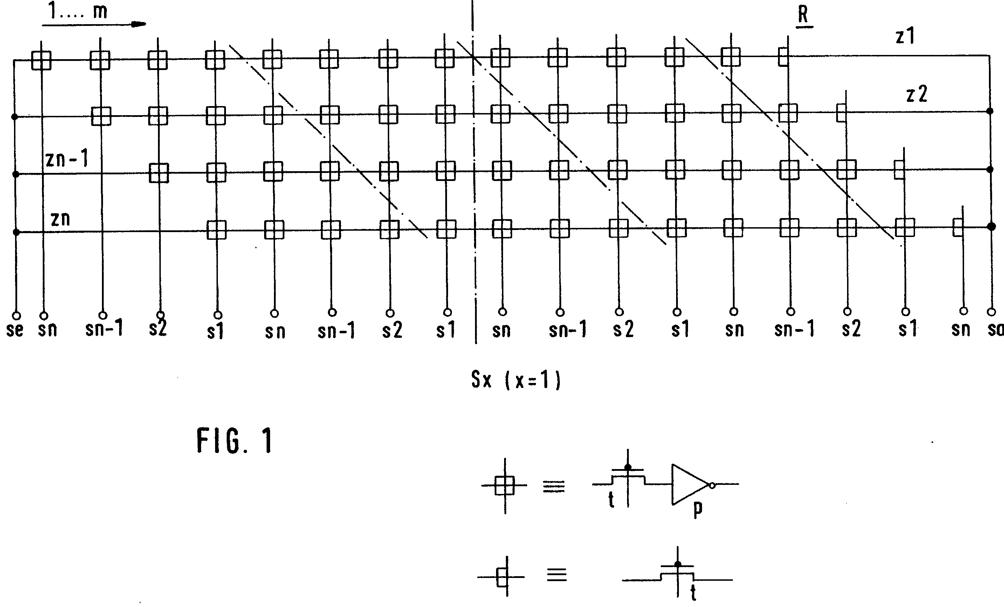

Im stark schematisierten Schaltbild der Fig. 1 sind von n möglichen die parallelen Signalzweige z1, z2, zn-1, zn gezeigt, wobei jeder Signalzweig m Transfertransistoren t aufweist, denen mit Ausnahme des m-ten der Pegelregenerierer p nachgeschaltet ist. Transfertransistor t und Pegelregenerierer p sind in der Zeichnung aus Vereinfachungsgründen zu einem kleinen Quadrat zusammengefaßt und im folgenden als Zellen bezeichnet, auf deren Numerierung der Übersichtlichkeit verzichtet ist. Transfertransistoren sind schematisch dadurch angedeutet, daß die linke Hälfte des erwähnten Quadrats gezeichnet ist.

Im Gegensatz zu der vorbeschriebenen Anordnung, bei der die Anzahl der Taktsignale der Anzahl der Transfertransistoren pro Signalzweig entspricht und gleichliegende Transistoren der einzelnen Signalzweige vom selben Taktsignal, also z.B. alle ersten Transfertransistoren vom letzten Taktsignal und alle letzten Transfertransistoren vom ersten Taktsignal angesteuert sind, sind bei dieser Anordnung nur soviele Taktsignale sl, s2, sn-1, sn vorgesehen, wie der Anzahl n der Signalzweige z1...zn entspricht. Ferner ist bei der Erfindung die Zuführung dieser Taktsignale an die Transfertransistoren t der Signalzweige in Richtung fallender Numerierung der Taktsignale versetzt vorgenommen. Somit sind im ersten Signalzweig z1 der erste sowie die in Richtung von steigenden m jeweils um n Transfertransistoren davon entfernt liegenden Transfertransistoren vom n-ten Taktsignal sn angesteuert, also außer dem ersten auch der $(n+1)$ste, der $(2n+1)$ste und der $(3n+1)$ste Transfertransistor. Da in Fig. 1 $n = 4$ ist, sind dies also der erste, der fünfte, der neunte und der dreizehnte Transfertransistor.

Bezeichnet man mit q die Anzahl der vom Signaleingang aus gerechnet vollständigen Blöcke aus n mal n Transfertransistoren, so ist in Fig. 1 q = 3 und der erwähnte dreizehnte Transistor ist der $(qn+1)$ste. Der erwähnte dreizehnte und der ihm folgende vierzehnte Transistor gehören dann zum Restblock R von r mal n Transfertransistoren, wobei gilt: $r<n$.

Im zweiten Signalzweig z2 wird der erste Transfertransistor vom $(n-1)$sten Taktsignal sn-1 gesteuert und ebenso wieder die entsprechenden Transfertransistoren, die um n, 2n...qn in Signalflußrichtung vom ersten Transistor entfernt liegen. Im vorletzten Signalzweig zn-1 werden der erste Transfertransistor und ebenso die um n, 2n...qn von ihm entfernt liegenden vom zweiten Taktsignal s2 und im letzten Signalzweig zn der erste Transfertransistor und die ihm entsprechenden weiteren vom ersten Taktsignal s1 angesteuert.

Im ersten Signalzweig z1 werden der zweite Transfertransistor und ebenso die von ihm um n, 2n...qn entfernt liegenden Transfertransistoren vom vorletzten Taktsignal sn-1 angesteuert. Im zweiten Signalzweig z2 wird der zweite Transfertransistor etc. vom zweiten Taktsignal s2, im vorletzten Signalzweig zn-1 der zweite Transfertransistor etc, vom ersten Taktsignal s1 und im letzten Signalzweig zn der zweite Transfertransistor etc. vom letzten Taktsignal sn angesteuert. In Fig. 1 kommt dieses "versetzte" Taktsteuerungsschema dadurch zum Ausdruck, daß die Transistoren der Signalzweige um jeweils eine Laufnummer gegenüber denen des über ihnen liegenden Signalzweigs versetzt angeordnet sind. Unter dem vierten Transfertransistor des Signalzweigs z1 liegen also der dritte des zweiten Signalzweigs z2 der zweite des vorletzten Signalzweigs zn-1 und der erste des letzten Signalzweigs zn.

Ein weiteres wesentliches Merkmal besteht darin, daß die Frequenz der Taktsignale s1...sn gleich dem n-ten Teil der Datenrate der Eingangssignale ist, die dem Signaleingang se zugeführt werden. Zu diesem Zweck sind die Eingänge der einzelnen Signalzweige zum Signaleingang se zusammengefaßt. Im Vergleich zur vorbeschriebenen Anordnung entfällt somit die eingangs erwähnte eingangsseitige Längskette. Im übrigen entfällt auch die ausgangsseitige Längskette, da die einzelnen Ausgänge der Signalzweige z1...zn zum Signalausgang sa des FIFO-Speichers zusammengefaßt sind.

Im erwähnten Restblock R erfolgt die Taktung der einzelnen Transfertransistoren der Signalzweige nach dem bereits erläuterten Schema. Da im Ausführungsbeispiel der Fig. 1 der Restblock R r = 2 Transistoren enthält, werden z.B. die beiden letzten Transistoren des letzten Signalzweigs zn vom ersten bzw. letzten Taktsignal s1, sn, angesteuert.

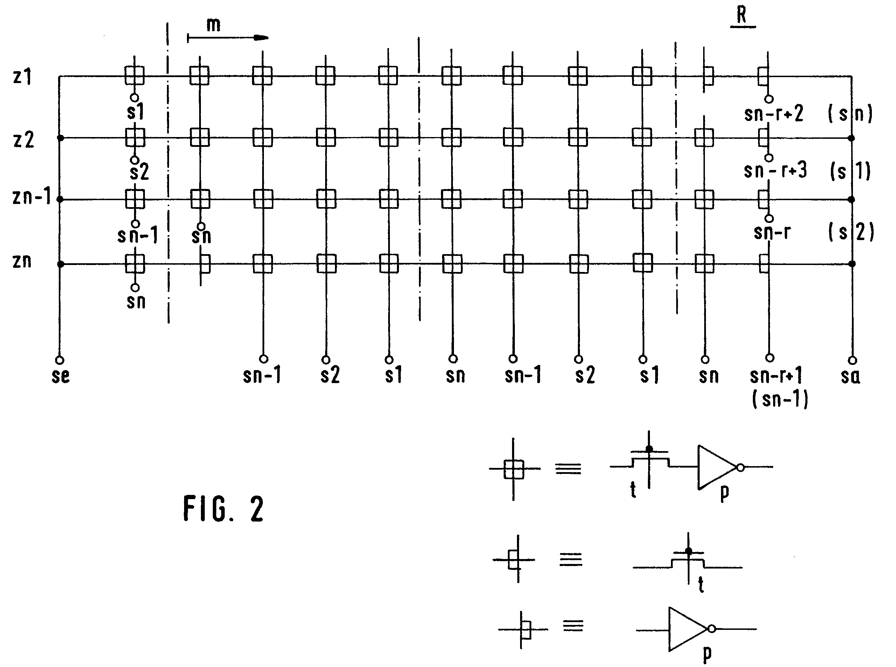

In Fig. 2 ist eine Abwandlung der Anordnung nach Fig. 1 gezeigt, bei der u.a. im Vergleich zur Anordnung nach Fig. 1 die Taktsignale anders zugeführt sind.

Im einzelnen ist in allen Signalzweigen z1...zn der jeweils ersten Zelle eine weitere Zelle vorgeschaltet, bei der dem Gate des jeweiligen Transfertransistors im ersten Signalzweig z1 das erste Taktsignal s1, im zweiten Signalzweig z2 das zweite Taktsignal s2, im vorletzten Signalzweig zn-1 das vorletzte Taktsignal sn-1 und im letzten Signalzweig zn das letzte Taktsignal sn zugeführt ist. Im letzten Signalzweig zn entfällt der erste Transfertransistor, so daß nur ein ungetakteter Pegelregenerierer in der ersten Zelle vorhanden ist. In Fig. 2 ist dies zeichnerisch dadurch veranschaulicht, daß nur die rechte Hälfte des erwähnten Quadrats gezeichnet ist.

Auch ausgangsseitig ist eine Änderung gegenüber der Anordnung nach Fig. 1 vorgenommen, und zwar dahingehend, daß dem Gate des letzten Transfertransistors des Restblocks R ein anderes Taktsignal als in Fig. 1 zugeführt ist. Im einzelnen ist im ersten Signalzweig z1 der vorletzte Transfertransistor weggelassen, so daß in der vorletzten Zelle nur der Pegelregenerierer vorhanden ist. Bei einem Restblock R von r mal n Transfertransistoren (r<n) ist dem Gate des letzten Transfertransistors entsprechend der Abwandlung das (n-r + 2)te Taktsignal sn-r + 2 zugeführt.

Im zweiten Signalzweig z2 ist der letzte Transfertransistor vom (n-r + 3)ten Taktsignal sn-r + 3, im vorletzten Signalzweig zn-1 vom (n-r)ten Taktsignal sn-r und im letzten Signalzweig zn vom (n-r + 1)-sten Taktsignal sn-r + 1 angesteuert. Da im Ausführungsbeispiel der Abwandlung nach Fig. 2 n = 4 und r = 2 ist und da die Summe n-r + ... bei Ergebnissen, die größer als n sind, um n zu vermindern ist, ist somit im ersten Signalzweig z1 der letzte Transfertransistor vom letzten Taktsignal sn, im zweiten Signalzweig z2 vom ersten Taktsignal s1, im vorletzten Signalzweig zn-1 vom zweiten Taktsignal s2 und im letzten Signalzweig zn vom vorletzten Taktsignal sn-1 angesteuert; diese Taktsignale sind in Fig. 2 in Klammern gesetzt.

In den Fig. 1 und 2 sind durch die gestrichelten schrägen bzw. senkrechten Linien die erwähnten Blöcke von n man n Zellen angedeutet. Aus Fig. 2 ist ersichtlich, daß bei dieser Abwandlung die Blöcke quadratisch angeordnet werden können, während sie in Fig. 1 rautenartig liegen. Für das Layout einer integrierten Schaltung ist daher die Anordnung nach Fig. 2 i.a. günstiger.

Als Pegelregenerierer p wird der in der gewählten Technologie verfügbare einfachste Inverter verwendet. Im Falle der Realisierung der Transfertransistoren als N-Kanal-Enhancement-MOS-Transistoren wird bevorzugt ein sogenannter Depletion-Load-Inverter verwendet, also ein Inverter, dessen Schalttransistor wieder ein Enhancement- und dessen Lasttransistor ein Depletiontransistor ist. Es kann aber auch eine aus drei mit ihren Schaltstrecken in Serie liegenden Transistoren bestehende Anordnung als Pegelregenerierer verwendet werden, wie sie in "IEEE Journal of Solid-State Circuits", 1984, Seiten 999 bis 1007, insb. Fig. 7 beschrieben ist. In diesem Fall sind die für eine solche Stufe erforderlichen beiden überlappenden Taktsignale aus dem jeweiligen Taktsignal s1...sn zu erzeugen.

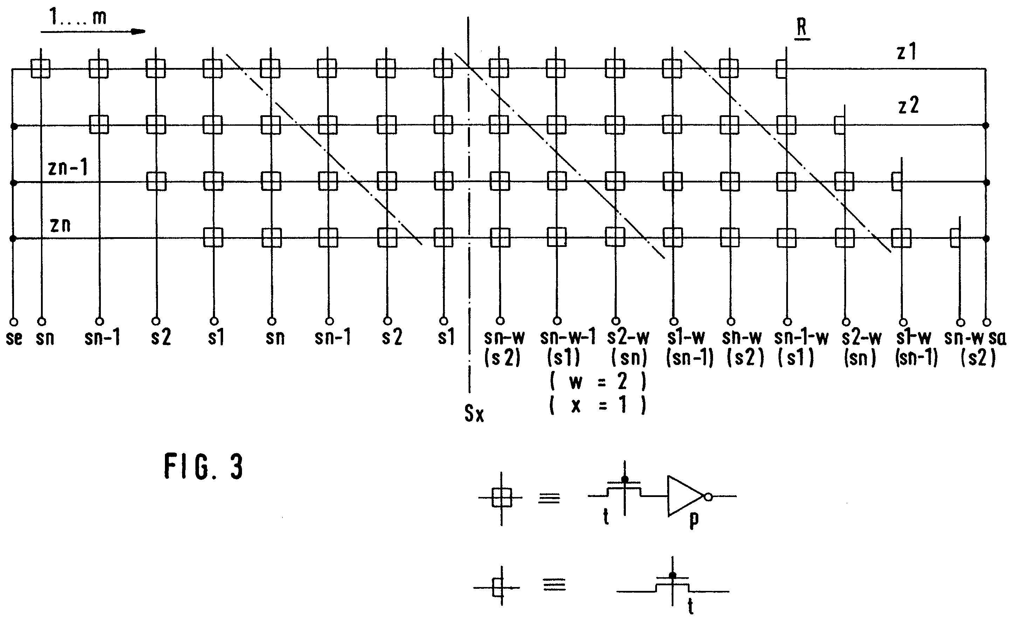

Die Fig. 3 zeigt eine Fig. 1 entsprechende Anordnung, bei der durch andere Zuführung der Taktsignale an einen Teil der Zellen die dort maximal mögliche Speicherzeit in Einheiten der Periodendauer der Datenrate verkürzt ist. Dies wird erfindungsgemäß dadurch erreicht, daß x Schnittstellen Sx vorgesehen werden, die jeweils zwischen zwei benachbarten, von je einem Taktsignal aufeinanderfolgender Numerierung angesteuerten Zellen liegt. In Fig. 1 liegt die Schnittstelle Sx zwischen Zellen, denen die Taktsignale s1, sn zugeführt sind. In Fig. 3 sind den rechts von der Schnittstelle Sx liegenden Zellen Taktsignale zugeführt, deren Numerierungszyklus bei den direkt an die Schnittstelle Sx grenzenden Zellen mit sn-w beginnt, wobei w zwischen 1 und W = n-2 wählbar ist; w gibt auch die Anzahl von Periodendauern der Datenrate an, worum sich an der Schnittstelle Sx die Speicherzeit verkürzt. Für w = 2 ist in Fig. 3 zusätzlich zu der allgemeinen Taktsignalnumerierung die entsprechende Numerierung in Klammern angegeben.

Für jede Schnittstelle Sx ist w in den angegebenen Grenzen wählbar. Somit ergibt sich in Datenrate-Periodendauer-Einheiten eine Gesamtverminderung der Verzögerung, die gleich der Summe über w ist. Ein Beispiel soll dies verdeutlichen. Ein FIFO-Speicher habe n = 8 Signalzweige mit je m = 20 Zellen. Es seien 6 Schnittstellen vorhanden, für die w1 = 1, w2 = 2, w3 = 3, w4 = 4, w5 = 5 gelten soll. Dann ist die Summe über w gleich 15.

Maximal kann der Numerierungszyklus daher so verändert werden, daß auf sn direkt sn + 1 folgt. Dann ist die Verweildauer des geschobenen Signals auf eine Periodendauer der Datenrate reduziert. Eine Schnittstelle muß gemäß Fig. 3 immer zwischen vollständig ausgebildeten Zellen in allen Signalzweigen liegen. Daher bietet sich für einen solchermaßen verkürzten FIFO-Speicher eine Konfiguration nach Fig. 2 an. Schnittstellen können an allen verfügbaren Stellen gleichzeitig vorgesehen werden. Dabei ist zu beachten, daß die Schaltgeschwindigkeitsanforderung an die Zellen mit der Verkürzung der Verweildauer des Signals wächst.

Soll ein FIFO-Speicher mit dieser Verkürzungsmöglichkeit der Speicherzeit ausgerüstet werden, so können z.B. hinter der (den) Schnittstelle(n) elektronische Umschalter vorgesehen werden, mit denen die erläuterte Zyklusänderung aller Taktsignale, die hinter der Schnittstellle zugeführt werden müssen, vorgenommen wird. Hierbei ist vorausgesetzt, daß jeweils einer der n Ausgänge eines Taktoszillators alle Klemmen entsprechender Numerierung speist, d.h. Klemmen gleicher Numerierung sind auch untereinander verbunden.

Es kann jedoch vorteilhafter sein, einen Taktoszillator vorzusehen, der für jeden Taktsignaleingang des FIFO-Speichers ein eigenes Taktsignal erzeugt, wobei die Taktsignale gleicher Numerierung untereinander phasengleich sein müssen, also für alle Taktsignaleingänge die Impulse gleichzeitig auftreten. Bei einem derartigen Taktoszillator läßt sich die erläuterte Speicherzeitverkürzung an einer Schnittstelle Sx sehr einfach durch entsprechende Verzögerung der Taktsignale im Taktoszillator erreichen.

Ist dieser z.B. ein m-stufiges Schieberegister, in dem ein Signalmuster vom Ende zum Anfang umläuft, das durch n im Abstand n-1 markierte Stufen bestimmt ist, so sind hinter der Schnittstelle Sx die Taktsignale aus den um w versetzten Schieberegisterstufen abzunehmen

## Patentansprüche

1. Serieller FIFO-Speicher mit Isolierschicht-Feldeffekttransistoren desselben Leitungs- und Steuerungstyps und mit n signalflußmäßig parallelen Signalzweigen (z1...zn), deren Eingänge mit dem Signaleingang (se) des Speichers und deren Ausgänge mit dessen Signalausgang (sa) gekoppelt sind, wobei

- jeder Signalzweig m Transfertransistoren enthält, deren Source-Drain-Strecken signalflußmäßig in Reihe liegen, und
- die Gates der Transfertransistoren jedes Signalzweigs mit Taktsignalen gespeist sind, deren wirksame Impulse in Richtung vom m-ten zum ersten Transfertransistor so zeitlich aufeinanderfolgen, daß sie nacheinander leitend gesteuert werden, mit folgenden Merkmalen:
- der Speicher dient ausschließlich als solcher für Digitalsignale,
- die Anzahl der Taktsignale ist gleich n und ihre Frequenz gleich dem n-ten Teil der Datenrate der Eingangssignale,
- die m Transfertransistoren jedes der n Signalzweige (z1, ..., zn) sind dabei in aufsteigender Reihenfolge von einen n-ten, einem (n-1)-ten, einem (n-2)-ten etc. und schließlich von einem ersten Taktsignal (sn, sn-1, sn-2, ...,s1) gesteuert, wobei sich diese Folge von Taktsignalen zyklisch bis zum Ende des jeweiligen Signalzweiges wiederholt, die zyklische Folge der Taktsignale ist dabei in aufeinanderfolgenden Signalzweigen entweder

- - jeweils um ein Taktsignal verzögert oder
- - in jedem Signalzweig (z1,..., zn) ist der jeweils ersten Zelle eine weitere Zelle vorgeschaltet, bei der dem Gate des jeweiligen Transfertransistors das erste bzw. zweite etc. bzw. n-te Taktsignal (s1, s2, ..., sn) zugeführt ist,
- - die letzten ( = m-ten) Zellen aufeinanderfolgender Signalzweige sind mit Taktsignalen gespeist, die jeweils um ein Taktsignal verzögert sind, wobei die anderen (m-1)-ten Transfertransistoren entsprechend ihrer aufsteigenden Reihenfolge mit aufeinanderfolgenden Taktsignalen (sn, sn-1, sn-2,..., s1) so gespeist sind, daß nummerngleiche Zellen der n Signalzweige (z1,..., zn) mit dem gleichen Taktsignal gespeist sind,

gekennzeichnet durch folgende Merkmale:

- es sind x Schnittstellen (Sx) vorgesehen, die jeweils zwischen zwei benachbarten von je einem Taktsignal aufeinanderfolgender Numerierung angesteuerten Zellen (z.B. z1, z2) liegen, und

- pro Schnittstelle (Sx) beginnt für die in Signalflußrichtung dahinter liegenden Zellen der Numerierungszyklus der Taktsignale mit dem sich um -w von dem den direkt vor der Schnittstelle liegenden Zellen zugeführten Taktsignalen unterscheidenden Taktsignal, wobei w zwischen 1 und w = n-2 wählbar ist und gleich der pro Schnittstelle auftretenden Anzahl von Periodendauern der Datenrate ist, wodurch die Speicherzeit des FIFO-Speichers sich an der jeweiligen Schnittstelle verkürzt.

2. Speicher nach Anspruch 1, dadurch gekennzeichnet, daß nur eine Schnittstelle vorgesehen ist und die Nunmerierungsdifferenz der Taktsignale an dieser Schnittstelle gleich w ist.

## Claims

1. A serial FIFO memory comprising insulated-gate field-effect transistors of the same conductivity and control type, as well as n signal branches (z1...zn) which extend parallel in terms of signal flow, with the inputs thereof being coupled to the signal input (se) of the memory, and with the outputs thereof being coupled to the signal output (sa) of the memory, with

- each signal branch containing m transfer transistors whose source-drain sections are arranged in series in in terms of signal flow, and
- with the gates of the transfer transistors of each signal branch being supplied with clock signals whose effective pulses, in direction from the m-th to the first transfer transistor, are in such a timely succession that the transistors are rendered conductive one at a time in turn, with following features:
- the memory exclusively serves as a memory for digital signals,
- the number of clock signals equals n, and their frequency or repetition rate equals the n-th part of the data rate of the input signals,
- the m transfer transistors in each of the n signal branches (z1,..., zn) are activated in ascending numbering direction by a n-th, a (n-1)st, a (n-2)nd, etc. and finally by a first clock signal (sn, sn-1, sn-2, ..., s1), whereby this sequence of clock signals is repeated in a cyclic manner up to the end of the respective signal branch,
- the cyclic sequence of the clock signals in succeeding signal branches is thereby either

- - delayed by a clock signal or
- - in each of the signal branches (z1...zn) the respective first cell is preceded by a further cell, in which to the gate of the respective transfer transistor there is applied the first or the second, etc. or respectively the n-th clock signal (s1...sn),
- - the last ( = m-th) cells of succeeding signal branches are fed with clock signals which are delayed by a clock signal whereby the other (m-1)st transfer transistors are, according to their ascending numbering direction, fed with succeeding clock signals (sn, sn-1, sn-2, ...., s1) in such a manner that cells of the n signal branches with equal numbers (z1, ..., zn) are fed with the same clock signal,

characterized by the following features:

- there are provided x interfaces (Sx) which each lie between two neighboring cells (e.g. z1, z2) each clocked (activated) by a clock signal of consecutive numbering, and
- per interface (Sx) the numbering cycle of the clock signals for the cells lying therebehind in the signal-flow direction begins with the clock signal differing by -w from those clock signals which are applied to the cells lying directly ahead of the interface, with w being selectable between 1 and w = n-2, and equal to the number of period durations of the data rate, appearing per interface, by which the storage time of the FIFO memory is reduced at the respective interface.

2. A memory as claimed in claim 1, **characterized** in that only one interface is provided for, and that the numbering difference of the clock signals at this particular interface equals w.

## Revendications

1. Mémoire FIFO série comportant des transistors à effet de champ à couche isolée, possédant les mêmes types de conduction et de commande et comportant n branches (z1...zn) de transmission de signaux, parallèles dans le flux de transmission des signaux et dont les entrées sont accouplées à l'entrée de transmission de signaux (se) de la mémoire et dont les sorties sont accouplées à la sortie de transmission de signaux (sa) de la mémoire, et dans laquelle

- chaque branche de transmission de signaux contient m transistors de transfert, dont les voies source-drain sont montées en série dans le flux de transmission de signaux, et
- les grilles des transistors de transfert de chaque branche de transmission de signaux sont alimentées par des signaux de cadence, dont les impulsions actives se succèdent dans le temps dans la direction allant du m-ème au premier transistor de transfert de sorte que les transistors sont placés successivement à l'état conducteur, et présentant les caractéristiques suivantes :
- la mémoire sert exclusivement de mémoire pour des signaux numériques,
- le nombre des signaux de cadence est égal à n et leur fréquence est égale à la n-ème partie de la cadence de données des signaux d'entrée,
- les m transistors de transfert de chacune des n branches de transmission de signaux (z1,...zn) sont commandés selon une succession croissante, par un n-ème, un (n-1)ème, un (n-2)ème, etc et finalement par un premier signal de cadence (sn,sn-1,sn-2,...s1), cette succession de signaux de cadence se répétant cycliquement jusqu'à la fin de la branche respective de transmission de signaux,
- dans des branches successives de transmission de signaux, la séquence cyclique des signaux de cadence est
  - - retardée respectivement d'un signal de cadence,
  - - ou bien, dans chaque branche de transmission de signaux (z1,...zn), est branchée en amont de la première cellule respective, une autre cellule, dans laquelle le premier, le second, etc ou le n-ème signal de cadence (s1,s2,...sn) est envoyé à la grille du transistor de transfert respectif,
  - - les dernières (= les m-èmes) cellules de branches successives de transmission de signaux sont alimentées par les signaux de cadence, qui sont respectivement retardés d'un signal de cadence, les autres (m-1)-èmes transistors étant alimentés, dans leur succession croissante, par des signaux de cadence successifs (sn,sn-1,sn-2,...s1) de sorte que des cellules possédant les mêmes numéros des n branches de transmission de signaux (z1,....zn) sont alimentées par le même signal de cadence,
caractérisé par les caractéristiques suivantes :

- il est prévu x interfaces (Sx) qui sont situées respectivement entre deux cellules voisines (par exemple (z1,z2), commandées respectivement par un signal de cadence possédant la numérisation successive, et
- pour chaque interface (Sx), pour les cellules situées en aval dans le sens du flux de transmission des signaux, le cycle de numérotation des signaux de cadence commence avec le signal de cadence qui diffère de -w du signal de cadence envoyé aux cellules situées directement en amont de l'interface, w pouvant être choisi entre 1 n-2 et étant égal au nombre, qui apparaît pour chaque interface, de durées de période de la cadence de données, ce qui réduit la durée de mémorisation de la mémoire FIFO au niveau de l'interface respective.

2. Mémoire selon la revendication 1, caractérisée en ce qu'il n'est prévu qu'une seule interface et que la différence de numérotation des signaux de cadence est égale à w au niveau de cette interface.

FIG. 1

$1 .... m$    $\underline{R}$   z1

z2

zn-1

zn

se  sn  sn-1  s2  s1  sn  sn-1  s2  s1  sn  sn-1  s2  s1  sn  sn-1  s2  s1  sn  sa

Sx (x=1)

EP 0 243 528 B1

FIG. 2

FIG. 3